# EUROPEAN PATENT APPLICATION

(11) **EP 4 174 224 A1**
(43) Date of publication of application: **03.05.2023**
(21) Application number: 21831490.4
(22) Date of filing: 29.06.2021
(51) Int. Cl.: C30B 29/36, C23C 14/06, C30B 23/06, H01L 21/205

(54) **METHOD FOR PRODUCING SIC CRYSTALS**

(30) Priority: 30.06.2020 JP 2020112418
(71) Applicant: Kyocera Corporation, Kyoto-shi Kyoto 612-8501 (JP)
(72) Inventor: ITOU, Seiichirou, Kyoto-shi, Kyoto 612-8501 (JP); ISHIZAKI, Yuichiro, Kyoto-shi, Kyoto 612-8501 (JP); UMEKI, Haruki, Kyoto-shi, Kyoto 612-8501 (JP)
(74) Representative: Viering, Jentschura & Partner mbB Patent- und Rechtsanwälte
(86) International application number: PCT/JP2021/024492
(87) International publication number: WO 2022/004703

(57) **Abstract**

A SiC crystal manufacturing method is based on a sublimation recrystallization method. The SiC crystal manufacturing method includes preparing a crucible including a support portion on an inner surface of the crucible; introducing raw material into the crucible; providing a stress-buffering sheet on the support portion, a bottom surface of the stress-buffering sheet having a region where a SiC crystal grows; installing a lid on the crucible, the lid having a projection on a surface thereof facing the stress-buffering sheet, the projection projecting towards the region of the stress-buffering sheet where the SiC crystal grows; and growing the SiC crystal on the bottom surface of the stress-buffering sheet by sublimating the raw material introduced into the crucible.

## Description

### TECHNICAL FIELD

The present disclosure relates to a SiC crystal manufacturing method.

### BACKGROUND OF INVENTION

A known existing method for manufacturing SiC crystals includes defining a space between the ceiling of a graphite vessel and the rear surface of a seed crystal by disposing the seed crystal on a shelf of the graphite vessel, disposing Si and C atom sources inside the graphite vessel, heating a furnace, and promoting gas phase transport from the Si and C atom sources to the seed crystal while making it unlikely that the rear surface of the seed will contact the ceiling by evacuating the induction furnace and directing a gas flow from below the seed crystal through the regions around the seed crystal to the center of the space between the ceiling of the graphite vessel and the seed crystal (refer to, for example, Patent Literature 1).

### CITATION LIST

### PATENT LITERATURE

Patent Literature 1: Japanese Unexamined Patent Application Publication (Translation of PCT Application) No. 2016-508948

### SUMMARY

### SOLUTION TO PROBLEM

In the present disclosure, a SiC crystal manufacturing method is based on a sublimation recrystallization method.

The SiC crystal manufacturing method includes
preparing a crucible that includes a support portion on an inner surface of the crucible,
introducing raw material into the crucible,
providing a stress-buffering sheet on the support portion, a bottom surface of the stress-buffering sheet having a region where SiC crystal grows,
installing a lid on the crucible, the lid having a projection on a surface thereof facing the stress-buffering sheet, the projection projecting towards the region of the stress-buffering sheet where the SiC crystal grows, and
growing the SiC crystal on the bottom surface of the stress-buffering sheet by sublimating the raw material introduced into the crucible.

### BRIEF DESCRIPTION OF THE DRAWINGS

FIG. 1 is a cross-sectional view of a manufacturing apparatus according to an embodiment of the present disclosure taken along the vertical direction.
FIG. 2A is an enlarged view illustrating an example of a cross section of a part (lid) of the manufacturing apparatus in FIG. 1 taken along the vertical direction.
FIG. 2B is an enlarged view illustrating another example of a cross section of a part (lid) of the manufacturing apparatus in FIG. 1 taken along the vertical direction.
FIG. 2C is an enlarged view illustrating another example of a cross section of a part (lid) of the manufacturing apparatus in FIG. 1 taken along the vertical direction.
FIG. 3 is an enlarged view of a cross section of a part (support member, stress-buffering sheet, lid) of the manufacturing apparatus in FIG. 1 taken along the vertical direction.
FIG. 4 is an enlarged view of a cross section of a part (support member, stress-buffering sheet, lid) of the manufacturing apparatus in FIG. 1 taken along the vertical direction.
FIG. 5A is a cross-sectional view illustrating part of the manufacturing apparatus in a raw material feeding step of a SiC crystal manufacturing method.
FIG. 5B is a cross-sectional view illustrating part of the manufacturing apparatus in a support member installation step of the manufacturing method.
FIG. 5C is a cross-sectional view illustrating part of the manufacturing apparatus in a stress buffering sheet installation step of the manufacturing method.
FIG. 5D is a cross-sectional view illustrating part of the manufacturing apparatus in a lid installation step of the manufacturing method.
FIG. 5E is a cross-sectional view illustrating the manufacturing apparatus in a vessel installation step of the manufacturing method.
FIG. 5F is a cross-sectional view illustrating the manufacturing apparatus in a growth step of the manufacturing method.
FIG. 6 is an enlarged view of a cross section of part (support member, stress-buffering sheet, lid) of the manufacturing apparatus in FIG. 1 taken along the vertical direction.
FIG. 7 is an enlarged view of a cross section of a part (stress-buffering sheet) of the manufacturing apparatus in FIG. 1 taken along the vertical direction.
FIG. 8 is a cross-sectional view of the manufacturing apparatus while SiC crystal is being manufactured taken along the vertical direction.

### DESCRIPTION OF EMBODIMENTS

SiC seed crystals are very hard (their ability to buffer stress is low). Therefore, if we try to grow SiC crystals from the bottom surface of a seed crystal as described in the above-listed Patent Literature 1, the seed crystal will be unable to sufficiently buffer the stress generated in the SiC crystal.

When SiC crystals are grown in a state where there is a space between the seed crystal and the lid as described in the above-listed Patent Literature 1, sublimated SiC gas flows around to the top surface of the seed crystal and recrystallizes on the top surface. Seed crystals that have SiC recrystallized on their top surfaces are more difficult to bend and deform due to their increased thickness, and consequently, their stress buffering performance when growing SiC crystals is further reduced.

However, according to the present disclosure, stress contained in SiC crystals being manufactured can be reduced from what was previously possible.

Hereafter, an embodiment of the present disclosure will be described in detail while referring to the drawings.

However, the technical scope of the present disclosure is not limited to that exemplified in the following embodiment and drawings.

### (1. SiC Crystal Manufacturing Apparatus)

First, the configuration of a manufacturing apparatus 100 (furnace) used in the manufacture of silicon carbide (SiC) crystals in this embodiment will be described.

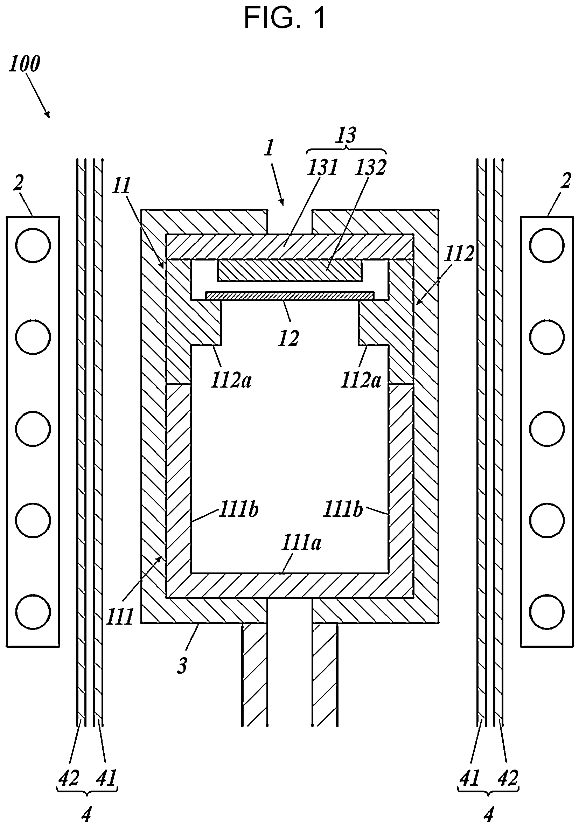

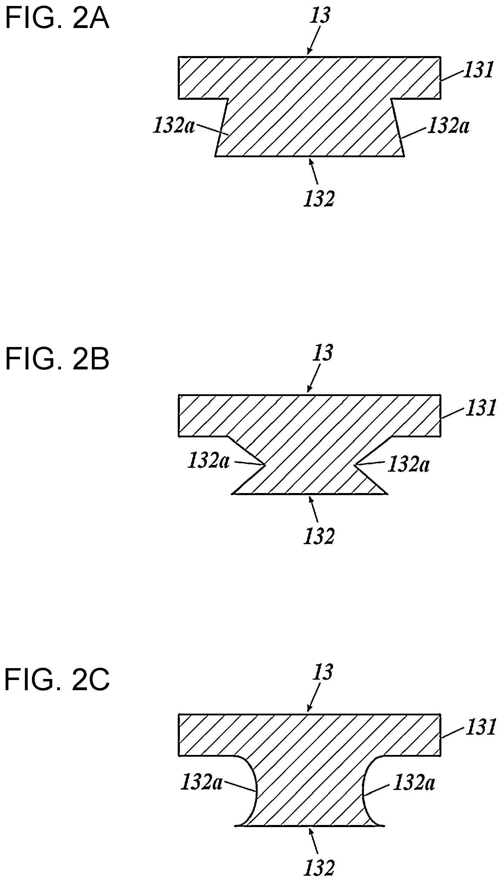

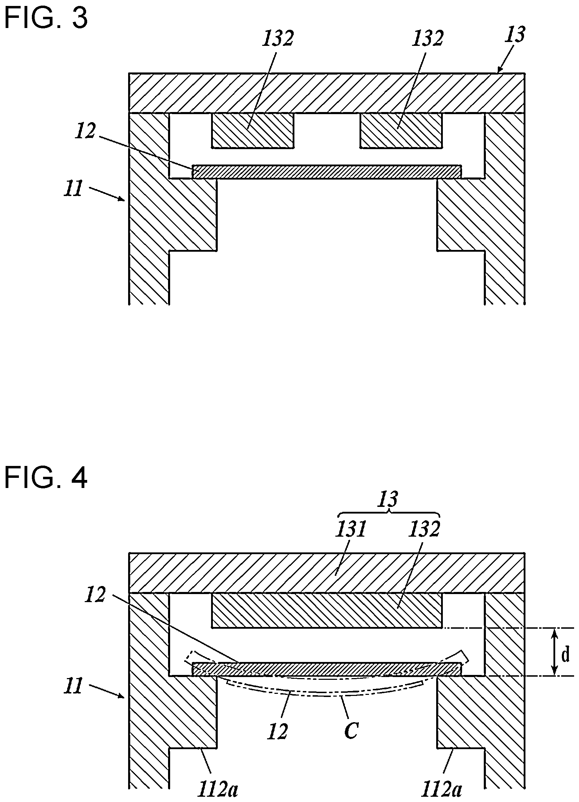

FIG. 1 is a cross-sectional view of the manufacturing apparatus 100 according to this embodiment taken along the vertical direction (crystal growth direction). FIGs. 2A to 2C and 3 are enlarged views of a cross section of part of the manufacturing apparatus 100 taken along the vertical direction.

The manufacturing apparatus 100 is used in the manufacture of SiC crystals using a sublimation recrystallization method.

As illustrated in FIG. 1, the manufacturing apparatus 100 according to this embodiment includes a vessel 1 and a coil 2.

The manufacturing apparatus 100 according to this embodiment further includes a heat insulator 3 and a quartz tube 4.

### (Vessel)

The vessel 1 includes a crucible 11, a stress-buffering sheet 12, and a lid 13.

The crucible 11 according to this embodiment includes a crucible body 111 and a support member 112.

The crucible body 111 includes a bottom part 111a and a side wall 111b, and is open at the top thereof.

The material of the crucible body 111 according to this embodiment is carbon.

The support member 112 is a cylindrical member that penetrates in the vertical direction.

The material of the support member 112 according to this embodiment is carbon.

A plan view outline of the support member 112 is approximately the same as a plan view outline of the crucible. Therefore, the support member 112 can be placed on the top surface of the crucible 11.

An inner wall surface of the support member 112 includes a support portion 112a. The support portion 112a protrudes in the direction of a central axis of the support member 112.

The support portion 112a may be provided along the entire periphery of the inner wall surface, or a plurality of the support portions 112a may be provided at intervals from each other.

The crucible 11 may also be configured such that the crucible body and the support member are integrated with each other.

The stress-buffering sheet 12 is a member on which SiC crystal grows on the bottom surface thereof.

The material of the stress-buffering sheet 12 according to this embodiment is carbon.

The stress-buffering sheet 12 is placed on the support portion 112a of the crucible 11. The thickness of the stress-buffering sheet 12 according to this embodiment lies in a range of 0.3 to 2.0 mm.

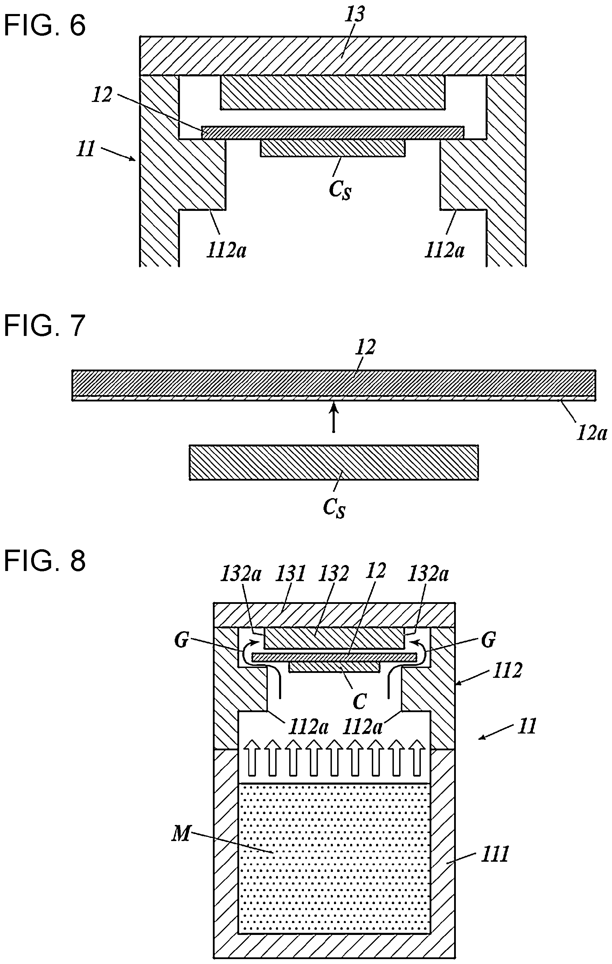

The stress-buffering sheet 12 may be provided with a high melting point protective film 12a (refer to FIG. 7) on the bottom surface thereof.

The high melting point protective film 12a is, for example, composed of tantalum carbide (TaC).

Any of a variety of existing known techniques can be used to form the high melting point protective film 12a.

The lid 13 includes a lid body 131 and a projection 132.

A plan view outline of the lid body 131 is substantially the same as a plan view outline of the crucible 11 (support member 112). Therefore, the lid body 131 can be placed on the top surface of the crucible 11.

The projection 132 projects from a surface (bottom surface) of the lid body 131 facing the stress-buffering sheet 12 towards a region (underside) of the stress-buffering sheet 12 where the SiC crystal will grow.

The projection 132 projects with a width corresponding to that of the region on the bottom surface of the stress-buffering sheet 12 where the SiC crystal will grow.

The "region where the SiC crystal will grow" refers to the region of the bottom surface of the stress-buffering sheet 12 that is not overlapped by the support portion 112a (i.e., is not shielded by the support portion 112a and is visible when looking upward from inside the crucible body 111).

The projection 132 is located within the region where the SiC crystal will grow and overlaps 80% or more of that region when viewed in plan view.

As illustrated in FIG. 2A, a side surface 132a of the projection 132 may be inclined so that the width of the projection 132 decreases with increasing proximity to the lid body 131 (increasing separation from the stress-buffering sheet 12).

As illustrated in FIGs. 2B and 2C, the side surface 132a of the projection 132 may be recessed.

As illustrated in FIG. 3, the lid 13 may include multiple projections 132. This would increase the area of the surface of the lid 13 on which SiC gas can be adsorbed and the SiC gas would be more likely to recrystallize on the lid 13. Therefore, SiC would be less likely to recrystallize on the top surface of the stress-buffering sheet 12.

As illustrated in FIG. 1, a space is formed between the lid 13 (projection 132) placed on the crucible 11 and the stress-buffering sheet 12.

The gap between the projection 132 and the stress-buffering sheet 12 is greater than the amount by which the stress-buffering sheet 12 will deform while the SiC crystal is growing.

In other words, as illustrated in FIG. 4, a distance d between the projection 132 and the stress-buffering sheet 12 before crystal growth is such that an upper edge (peripheral edge) of the stress-buffering sheet 12, which bends and deforms so as to be downwardly convex during the growth of SiC crystal C (indicated by the dashed line in FIG. 4), does not contact the bottom surface of the projection 132.

### (Heat Insulator)

As illustrated in FIG. 1, the heat insulator 3 covers the vessel 1.

### (Quartz Tube)

The quartz tube 4 surrounds heat insulator 3 from the outside.

The quartz tube 4 is a double tube consisting of an inner tube 41 and an outer tube 42.

Water can be passed between the inner tube 41 and the outer tube 42.

### (Coil)

The coil 2 is used to heat the vessel 1 by high-frequency induction heating.

The coil 2 surrounds the quartz tube 4 from the outside.

The vessel 1 may be heated by resistance heating using a heater instead of the coil 2.

### (2. SiC Crystal Manufacturing Method)

Next, a method for manufacturing a SiC crystal C using the manufacturing apparatus 100 will be described.

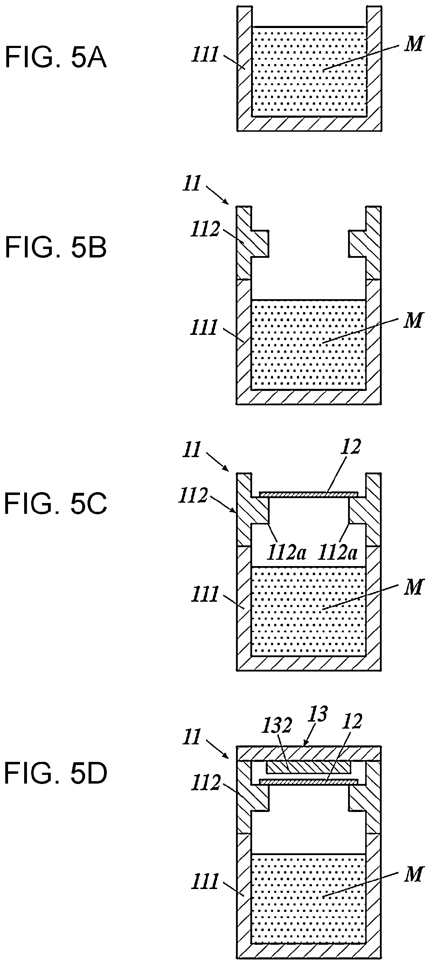

FIGs. 5A to 5F are cross-sectional views illustrating steps of the method for manufacturing a SiC crystal. FIGs. 6 and 7 are enlarged views of a cross section of part of the manufacturing apparatus 100 taken in a vertical direction. FIG. 8 is a cross-sectional view of the manufacturing apparatus 100 while SiC crystal is being manufactured taken along the vertical direction.

Manufacture of the SiC crystal C is performed using a sublimation recrystallization method.

The method for manufacturing the SiC crystal C includes a crucible preparation step, a raw material feeding step, a stress-buffering sheet installation step, a lid installation step, and a growth step.

The method for manufacturing the SiC crystal C according to this embodiment further includes a support member installation step, an evacuation step, and a cooling/removal step.

### (Crucible Preparation Step)

In the initial crucible preparation step, the crucible 11 including the support portion 112a on the inner surface thereof is prepared.

### (Raw Material Feeding Step)

After the crucible 11 has been prepared, the process moves on to the raw material feeding step.

In the raw material feeding step, as illustrated in FIG. 5A, SiC crystal raw material M (SiC crystal powder) is introduced into the crucible 11 (crucible body 111).

### (Support Member Installing Step)

Once the raw material M has been introduced into the crucible 11, the method for manufacturing the SiC crystal according to this embodiment moves on to the support member installation step.

As illustrated in FIG. 5B, in the support member installation step, the support member 112 is installed on the crucible body 111 into which the raw material M has been introduced.

If the crucible 11 is a crucible in which the crucible body and the support member are integrated with each other, this support member installation step is not necessary.

### (Stress-Buffering Sheet Installation Step)

Once the support member 112 has been installed on the crucible body 111, the process moves on to the stress-buffering sheet installation step.

In the stress-buffering sheet installation step, the stress-buffering sheet 12, which has a region on the lower surface thereof where the SiC crystal C will grow, is provided on the support portion 112a of the crucible 11.

Specifically, as illustrated in FIG. 5C, the peripheral portion of the stress-buffering sheet 12 is placed on the support portion 112a of the support member 112.
In the stress-buffering sheet installation step according to this embodiment, the thickness of the stress-buffering sheet 12 is in a range of 0.3 to 2.0 mm. In this way, the rigidity of the stress-buffering sheet 12 is maintained and a situation in which the growing SiC crystal C falls can be avoided.

Note that the stress-buffering sheet 12 may be provided on the support portion 112a at a timing before installing the support member 112 on the crucible body 111.

In other words, the support member 112 may be placed on the crucible body 111 after placing the stress-buffering sheet 12 on the support portion 112a of the support member 112.

### (Lid Installation Step)

After providing the stress-buffering sheet 12 on the support portion 112a of the crucible 11, the process moves on to the lid installation step.

In the lid installation step, the lid 13 including the projection 132 is installed on the crucible 11.

Specifically, as illustrated in FIG. 5D, the lid 13 is placed on the support member 112 so that the projection 132 is positioned inside the support member 112.

Thus, the projection 132 projects towards the region where the SiC crystal C will grow on the stress-buffering sheet 12.

In the support member installation step or the lid installation step, it is ensured that the gap between the projection 132 and the stress-buffering sheet 12 is larger than the amount by which the stress-buffering sheet 12 will deform while the SiC crystal C is growing.

Specifically, the width of the above-described space is secured by adjusting the distance between the top edge of the crucible 11 and the top surface of the support portion 112a, or the thickness of the projection 132 of the lid 13.

A seed crystal attaching step may be inserted prior to the growth step, which is described later.

In this seed crystal attaching step, a SiC crystal manufactured using the sublimation recrystallization method is attached, as a seed crystal CS, to the bottom surface of the stress-buffering sheet 12 or the bottom surface of the high melting point protective film 12a, as illustrated in FIGs. 6 and 7.

In this way, SiC crystals having a large grain size and high thermal conductivity can be manufactured from the initial stage of growth.

If the seed crystal is attached to the bottom surface of the high melting point protective film 12a, diffusion of Si into the stress-buffering sheet 12 during the growth of SiC crystal C is reduced and therefore defects are less likely to occur in the SiC crystal being grown.

The high melting point protective film 12a may be provided on the top surface of the seed crystal CS.

When attaching the seed crystal CS to the stress-buffering sheet 12, a hexagonal SiC (a-SiC) polycrystal substrate may be used as the seed crystal CS, and the seed crystal CS may be attached to the bottom surface of the stress-buffering sheet 12 so that the growth plane of the seed crystal CS is oriented substantially along the C-plane ((0001) plane).

α-SiC has high thermal conductivity, and the growth rate is increased when α-SiC is oriented along the C-plane. In this way, the SiC crystal can be efficiently manufactured.

### (Vessel Installation Step)

Once the lid 13 has been installed on the crucible 11, the process moves on to the vessel installation step.

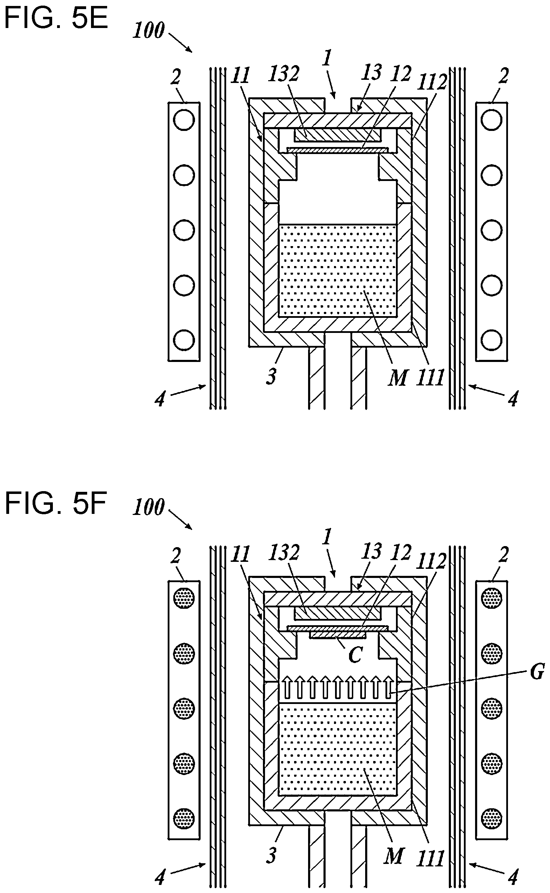

As illustrated in FIG. 5E, in the vessel installation step, the vessel 1 is disposed inside the heat insulator 3 of the manufacturing apparatus 100.

### (Evacuation Step)

Once the vessel 1 has been installed inside the heat insulator 3, the process moves on to the evacuation step.

In the evacuation step, the interior of the manufacturing apparatus 100 is evacuated and filled with an inert gas.

### (Growth Step)

Once the lid 13 has been installed on the crucible 11, the process moves on to the growth step.

In the growth step, as illustrated in FIG. 5F, the raw material M in the crucible 11 is sublimated so as to grow the SiC crystal C on the bottom surface of stress-buffering sheet 12.

Specifically, a high-frequency alternating current is energized in the coil 2. Then, high-density eddy currents are generated in the vessel 1. The vessel 1 is then heated up by the eddy currents up to the temperature at which the raw material M sublimates.

SiC gas G produced by the sublimation of the raw material M rises to the height of the stress-buffering sheet 12 and recrystallizes on the bottom surface of the stress-buffering sheet 12.

As illustrated in FIG. 8, some of the SiC gas G produced by the sublimation of the raw material M passes through the gap between the support portion 112a of the crucible 11 and the stress-buffering sheet 12 and flows around to the side where the lid 13 is located.

During the growth of SiC crystal, the SiC gas G that has flowed around to the side where the lid 13 is located recrystallizes mainly on the side surface 132a of the projection 132. This makes it less likely that the SiC will recrystallize on the top surface of the stress-buffering sheet 12.

As a result, the stress buffering performance of the stress-buffering sheet 12 is maintained during the growth of the SiC crystals, and the stress contained in the manufactured SiC crystals is reduced from what was previously possible.

As described above, the projection 132 of the lid 13 according to this embodiment is located within the region where the SiC crystal C grows and overlaps 80% or more of that region when viewed in plan view. This makes it less likely for the SiC to recrystallize in numerous regions on the top surface of the stress-buffering sheet 12 during the growth step described above. As a result, a region where the stress-buffering sheet 12 can deform for the purpose of stress buffering can be sufficiently secured.

When the side surface 132a of the projection 132 is recessed or sloped so that the width of the projection 132 decreases with increasing separation from the stress-buffering sheet 12, the surface area of the projection 132 is increased. This increases the amount of adsorption of the SiC gas that has flowed around to the side where the lid 13 is located during the growth step, and therefore it becomes less likely for the SiC gas that has flowed around to the side where the lid 13 is located to reach the top surface of the stress-buffering sheet 12.

As described above, the space between the projection 132 and the stress-buffering sheet 12 according to this embodiment is greater than the amount of deformation of the stress-buffering sheet 12 that occurs while the SiC crystal C is growing. Therefore, in the growth step, further deformation of the deformed stress-buffering sheet 12 resulting from the stress-buffering sheet 12 contacting the projection 132 is obstructed, and reduction of the stress buffering performance can be avoided.

As described above, the stress-buffering sheet 12 is only placed on the support portion 112a of the crucible 11. This makes it more difficult for heat to be transferred from the crucible 11 to stress-buffering sheet 12 during the growth step, and this results in a uniform temperature distribution in planar directions (horizontal directions) of the stress-buffering sheet 12. As a result, flat SiC crystals can be manufactured and the product yield is improved.

### (Cooling/Removal Step)

Once a SiC crystal of a prescribed length has been grown, the process moves onto the cooling/removal step.

In this cooling/removal step, the temperature inside the manufacturing apparatus 100 is lowered in stages.

Once the temperature inside the manufacturing apparatus 100 has fallen to a prescribed temperature, the vessel 1 is removed from inside the heat insulator 3, the stress-buffering sheet 12 is removed from the crucible 11, and the SiC crystal is removed from the stress-buffering sheet 12.

In this way, a SiC crystal is manufactured.

### (3. Effects)

According to the SiC crystal manufacturing method described above, during the growth of a SiC crystal, SiC gas G that has flowed around to the side near the lid 13 recrystallizes mainly on the side surface 132a of the projection 132, and consequently the gas is less likely to recrystallize on the top surface of the stress-buffering sheet 12.

Therefore, the stress contained in the manufactured SiC crystal can be reduced from what was previously possible.

As a result, SiC crystals having fewer grain boundaries and higher thermal conductivity (around 300 to 380 W/m-K) can be manufactured with a higher yield compared with SiC crystals manufactured using a sintering method (containing a sintering aid).

### (4. Other Considerations)

It goes without saying that the present disclosure is not limited to the above embodiment and so forth and may be changed as appropriate without departing from the intent of the present disclosure.

For example, the seed crystal attached to the bottom surface of the stress-buffering sheet 12 may be a SiC single crystal.

A seed crystal may be placed instead of the stress-buffering sheet 12. This would have the effect of reducing the amount of SiC gas G flowing around to the top surface of the seed crystal.

### INDUSTRIAL APPLICABILITY

The present invention can be used in SiC crystal manufacturing methods.

### REFERENCE SIGNS

100 manufacturing apparatus
1 vessel
11 crucible
111 crucible body
112 support member
112a support portion
12 stress-buffering sheet
12a high melting point protective film
13 lid
131 lid body
132 projection
132a side surface
2 coil
3 heat insulator
4 quartz tube
C SiC crystal
CS seed crystal
M raw material

## Claims

1. A SiC crystal manufacturing method based on a sublimation recrystallization method, the SiC crystal manufacturing method comprising:
preparing a crucible that includes a support portion on an inner surface of the crucible;
introducing raw material into the crucible;
providing a stress-buffering sheet on the support portion, a bottom surface of the stress-buffering sheet having a region where SiC crystal grows;
installing a lid on the crucible, the lid having a projection on a surface thereof facing the stress-buffering sheet, the projection projecting towards the region of the stress-buffering sheet where the SiC crystal grows; and
growing the SiC crystal on the bottom surface of the stress-buffering sheet by sublimating the raw material introduced into the crucible.

2. The SiC crystal manufacturing method according to claim 1,
wherein the projection is located inside the region where the SiC crystal grows and overlaps 80% or more of that region when viewed in plan view.

3. The SiC crystal manufacturing method according to claim 1,
wherein a gap between the projection and the stress-buffering sheet is larger than an amount of deformation of the stress-buffering sheet that occurs while the SiC crystal is growing.

4. The SiC crystal manufacturing method according to claim 1,
wherein a side surface of the projection is recessed or sloped so that a width of the projection decreases with increasing separation from the stress-buffering sheet.

5. The SiC crystal manufacturing method according to any one of claims 1 to 4,
wherein a thickness of the stress-buffering sheet is from 0.3 to 2.0 mm.

6. The SiC crystal manufacturing method according to any one of claims 1 to 5,
wherein the stress-buffering sheet is provided with a high melting point protective film on a bottom surface thereof.

7. The SiC crystal manufacturing method according to any one of claims 1 to 6,
wherein a SiC crystal manufactured by a sublimation recrystallization method is attached, as a seed crystal, to a bottom surface of the stress-buffering sheet or a bottom surface of the high melting point protective film.

8. The SiC crystal manufacturing method according to claim 7,
wherein a hexagonal SiC polycrystal substrate is used as the seed crystal, and
when the seed crystal is attached, the seed crystal is substantially oriented along a C plane.
